# EUROPEAN PATENT SPECIFICATION

(11) **EP 2 592 653 B1**
(45) Date of publication and mention of the grant of the patent: **30.11.2016**
(21) Application number: 12152760.0
(22) Date of filing: 26.01.2012
(51) Int. Cl.: H01L 27/12

(54) **Method of manufacturing flexible electronic device**
Herstellungsverfahren für eine flexible elektronische Vorrichtung
Procédé de fabrication de dispositif électronique flexible

(30) Priority: 09.11.2011 US 201113292599
(43) Date of publication of application: 15.05.2013
(73) Proprietor: AU Optronics Corporation, Hsin-Chu (TW)
(72) Inventor: Fang, Chun-Hsiang, Hsin-Chu (TW); Lin, Yu-Ling, Hsin-Chu (TW)
(74) Representative: Lang, Christian

(56) References cited:
- EP-A1- 0 323 882
- US-A1- 2007 049 064
- US-A1- 2007 065 993
- US-A1- 2010 068 483
- US-A1- 2010 124 635
- US-A1- 2010 291 391
- US-A1- 2011 092 006
- US-A1- 2011 124 183

## Description

### FIELD OF THE INVENTION

The present invention relates generally to a flexible electronic device, and more particularly, to a method for manufacturing a flexible electronic device.

### BACKGROUND OF THE INVENTION

There are two methods mainly applied in manufacturing flexible displays: roll to roll and attaching a flexible substrate to a glass substrate. For the latter method, separating the flexible substrate from the glass substrate so as to complete the flexible display manufacturing process has been proven to be challenged. One of conventional release methods is to insert a sacrificial layer between the flexible substrate and the glass substrate in which the material of the sacrificial layer are oxides that absorb energy of laser at certain wavelengths. By laser scanning the rear side of the glass substrate, the oxide layer absorbs the laser energy penetrated through the glass substrate, so that the flexible substrate and the glass substrate are separated. However, the use of laser increases the cost and induces damages to electronic components.

Another method is to dispose an organic release layer between the flexible substrate and the glass substrate. However, during the process the organic release layer may form small islands, which may cause holes to be formed in the flexible substrate and non-uniform thickness of the flexible substrate.

Therefore, a heretofore unadressed need exists in the art to address the aforementioned deficiencies and inadequacies.

US 2011/92006 A1 describes a method for fabricating a display device, comprising the steps of forming an adhesive layer of an organic material on a carrier substrate, forming a plurality of adhesive patterns of a metallic material on the adhesive layer, forming a plastic substrate on the adhesive layer and the plurality of adhesive patterns, forming a plurality of elements for displaying images on the plastic substrate and cutting the carrier substrate and the plastic substrate for detaching the carrier substrate from the carrier substrate.

US 2010/68483 A1 relates to a method for manufacturing a flexible electrical device including the steps of forming a release layer comprising parylene or cyclic olefin polymers on a carrier substrate, forming a flexible substrate which serves as carrier for a electronic device layer on said release layer and cutting a portion of the flexible substrate and the carrier along the contour of the release layer to separate the release layer and the flexible substrate from the carrier.

It is the object of the present invention to provide an improved method for manufacturing a flexible electronic device.

### SUMMARY OF THE INVENTION

This object is solved by the method for manufacturing a flexible electronic device according to claim 1. An advantageous improvement of the method is described by dependent claim 2.

A method for manufacturing a flexible electronic device may include providing a substrate, forming a first layer on the substrate to define a first area and a second area surrounding the first area in the substrate such that the substrate is exposed at least partially in the first area and at least a portion of the first layer is in the second area, forming a second layer on the first area and the first layer over the second area such that an adhesion force between the second layer and the substrate in the first area is weaker than that between the second layer and the first layer in the second area, forming an electronic device layer on the second layer over the first area, where the electronic device layer defines a boundary thereon, and the boundary is projectively within the first area, and separating the electronic device layer and the partial second layer from the substrate by cutting through the second layer along a contour that is equal to or larger than the boundary of the electronic device layer but within the first area.

According to the present invention, a method for manufacturing a flexible electronic device comprises providing a substrate having a first surface and an opposite, second surface, coating a first polyamic acid on the first surface of the substrate to form a first polyimide (PI) layer so as to define a first area on which the first PI layer is formed and a second area surrounding the first area in the substrate, coating a second polyamic acid which synthesized with organic silane on the first PI layer in the first area of the substrate and on the second area of the substrate to form a second PI layer thereon, such that an adhesion force between the first PI layer and the substrate in the first area is weaker than that between the second PI layer and the substrate in the second area, forming an electronic device layer on the second P1 layer over the first area, where the electronic device layer defines a boundary thereon, and the boundary is projectively within the first area, and separating the electronic device layer, the partial second PI layer and the partial first PI layer from the substrate by cutting through the second PI layer and the first PI layer along a contour that is equal to or larger than the boundary of the electronic device layer but within the first area.

This and other aspects of the present invention will become apparent from the following description of the preferred embodiment taken in conjunction with the following drawings, although variations and modifications therein may be affected without departing from the scope of the novel concepts of the disclosure.

### BRIEF DESCRIPTION OF THE DRAWINGS

The accompanying drawings illustrate one or more embodiments of the invention and, together with the written description, serve to explain the principles of the invention. Wherever possible, the same reference numbers are used throughout the drawings to refer to the same or like elements of an embodiment, and wherein:
FIGS. 1A-1G show schematically processes for manufacturing a flexible electronic device;
FIGS. 2A-2H show schematically processes for manufacturing a flexible electronic device; and
FIGS. 3A-3H show schematically processes for manufacturing a flexible electronic device according to an embodiment of the present invention.

### DETAILED DESCRIPTION OF THE INVENTION

The present invention will now be described more fully hereinafter with reference to the accompanying drawings, in which exemplary embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed as a second element, component, region, layer or section without departing from the teachings of the present invention.

The terminology used herein is for the purpose of describing particular embodiments only and is not intended to be limiting of the invention. As used wherein, the singular forms "a", "an" and "the" are intended to include the plural forms as well, unless the context clearly indicates otherwise. It will be further understood that the terms "comprises" and/or "comprising", or "includes" and/or "including" or "has" and/or "having" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lowed" or "bottom" and "upper" or "top", may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower", can therefore, encompasses both an orientation of "lower" and "upper, " depending of the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly format sense unless expressly so defined herein.

As used herein, "around", "about" or "approximately" shall generally mean within 20 percent, preferably within 10 percent, and more preferably within 5 percent of a given value or range. Numerical quantities given herein are approximate, meaning that the term "around", "about" or "approximately" can be inferred if not expressly stated.

As used wherein, the terms "comprising", "including", "carrying", "having", "containing", "involving" and the like are to be understood to be open-ended, i.e., to mean including but not limited to.

The term "layer", as used herein, refers to a thin sheet or thin firm.

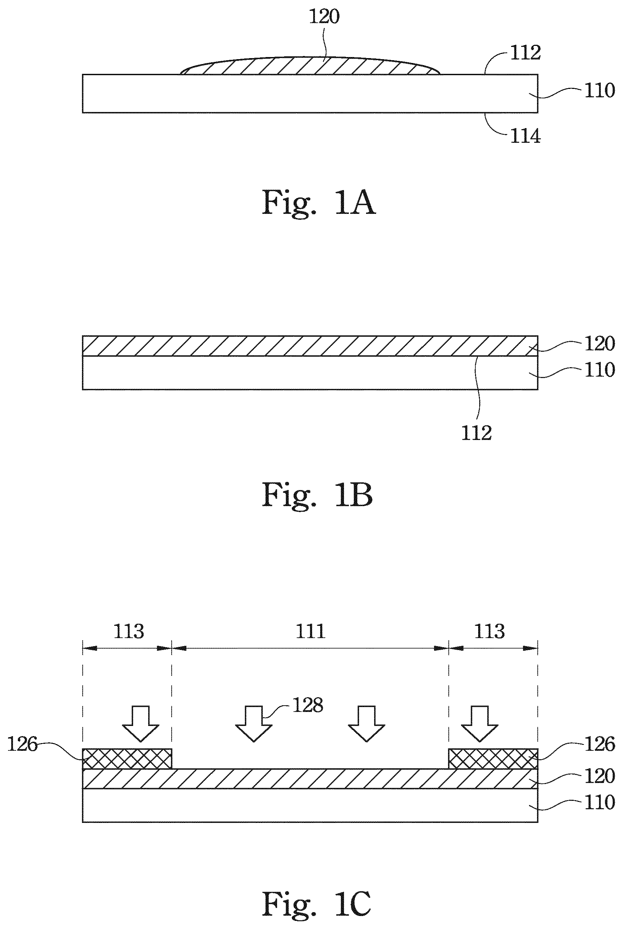

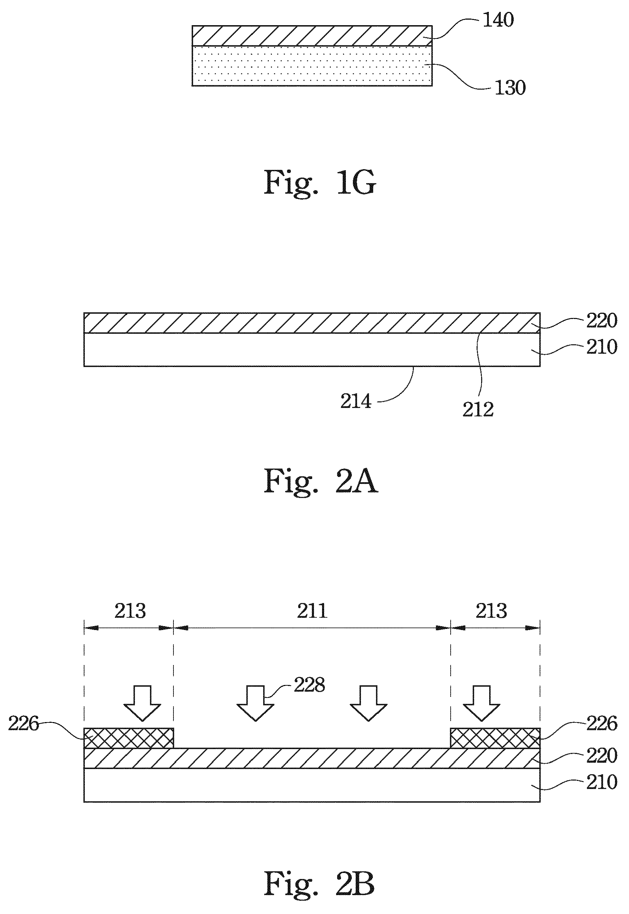

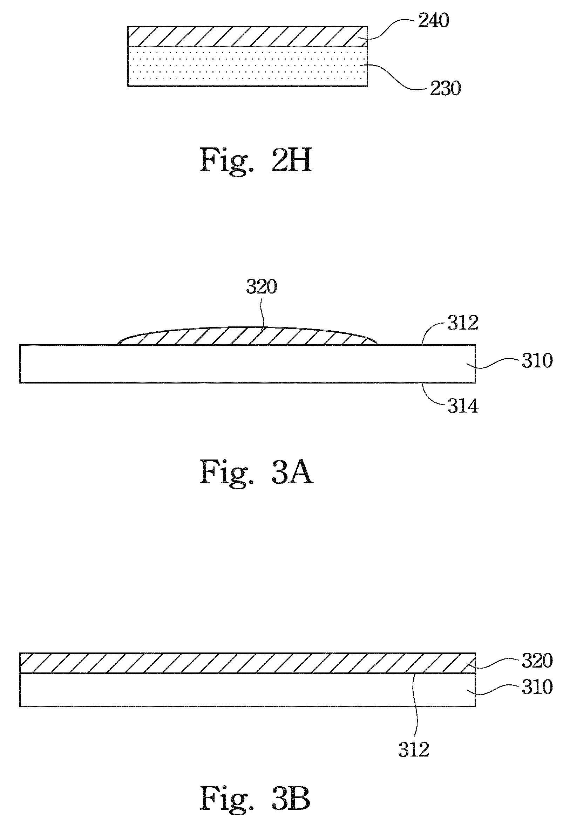

The description will be made as to the embodiments in conjunction with the accompanying drawings in FIGS. 1A-1G, 2A-2H and 3A-3H, wherein FIGS. 1A-1C and 2A-2H show embodiments of manufacturing a flexible electronic device, which are not in accordance with the present invention but helpful for the understanding thereof, and wherein FIGS. 3A-3H present an embodiment of the present invention. In accordance with the purposes of this invention, as embodied and broadly described herein, this invention, in one aspect, relates to a method for manufacturing a flexible electronic device.

Referring now to FIGS. 1A-1G, a method for manufacturing a flexible electronic device is shown according to an embodiment, which is not in accordance with the present invention, but helpful for the understanding thereof. The method includes the following steps: At first, a substrate 110 having a first (flat) surface 112 and an opposite, second surface 114 is provided. The substrate 110 can be a flat substrate of glass, quartz, plastic, ceramic, metal, or the like. In the exemplary embodiment, the substrate 110 is a flat glass substrate.

An adhesion promoting layer 120 is then formed on the first surface 112 of the substrate 110 with an adhesion promoting material, as shown in FIG. 1B. In the example, the adhesion promoting material is organic silane. It is understood that other adhesion promoting material can also be utilized.

In one embodiment, forming the adhesion promoting layer 120 includes the steps of coating the first surface 112 of the substrate 110 with the adhesion promoting material of organic silane, and baking the organic silane coated substrate 110 at a first temperature for a first period of time to form the adhesion promoting layer 120 on the substrate 110, as shown in FIG. 1B. The coating process includes applying an excess amount of a solution of organic silane to the first surface 112 of the flat substrate 110, as shown in FIG. 1A, and then rotating them at high speed to spread the solution of organic silane to form the organic silane coated substrate. In one embodiment, the first temperature is in a range of about 50-250 °C, and the first period of time is in a range of about 5-10 min. Preferably, the baking (first) temperature and time are about 120 °C and about 5 min, or about 200 °C and about 1 min.

In another embodiment, forming the adhesion promoting layer 120 includes vapor coating the first surface 112 of the substrate 110 with the adhesion promoting material to form the adhesion promoting layer 120, as shown in FIG. 1B. The vapor coating process can be a physical vapor deposition (PVD) process, chemical vapor deposition (CVD) process, or the like.

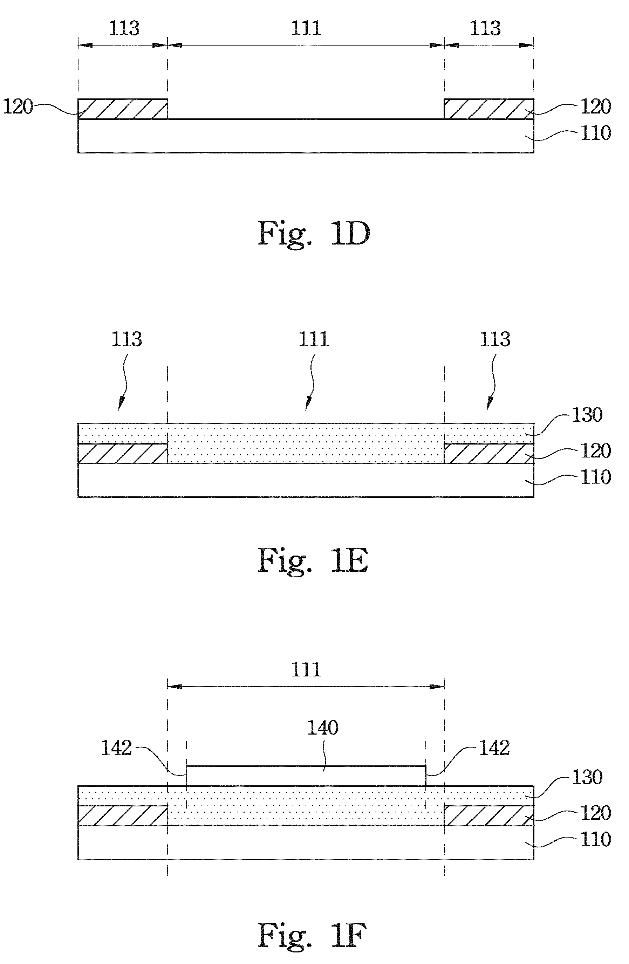

Further, a patterning process is performed on the adhesion promoting layer 120 to define a first area 111 and a second area 113 that surrounds the first area 111 in the substrate 110. In one embodiment, the patterning process includes transferring a mask 126 having a pattern corresponding to the first area 111 and the second area 113 over the adhesion promoting layer 120, and treating them with UV light 128 in an environment of air or oxygen, for example, an oven, such that the adhesion promoting layer 120 on the first area 111 is illuminated with the UV light and the adhesion promoting layer 120 on the second area 113 is masked from the UV light, as shown in FIG. 1C. The patterning process is performed at a second temperature for a second period of time. The second temperature is in a range of about 25-300 °C, and the second period of time is in a range of about 1-10 min. Preferably, the second temperature and time are about 200 °C and about 5 min. Additionally, the portion of the adhesion promoting layer 120 on the first area 111 is removed by UV light so that the first surface 112 of the substrate 110 is exposed in the first area 111, while the adhesion promoting layer 120 is only on the second area 113, as shown in FIG. 1D.

Next, a plastic layer 13D is formed on the first area 111 and the adhesion promoting layer 120 over the second area 113, as shown in FIG. 1E. The plastic layer 130 of PI, for example, is flexible and used as a base of the flexible electronic components and/or devices. In one embodiment, the step of forming the plastic layer includes coating the first area 111 and the adhesion promoting layer 120 over the second area 113 with polyamic acid (PAA) to form a polyamic acid layer thereon, and curing the polyamic acid layer to form the plastic layer 130. As such, an adhesion force between the plastic layer 130 and the substrate 110 in the first area 111 is weaker than that between the plastic layer 130 and the adhesion promoting layer 120 in the second area 113. It is understood that other materials can also be utilized to form the flexible plastic layer.

Additionally, an electronic device layer 140 is formed on the plastic layer 130 over the first area 111 in which the electronic device layer 140 defines a boundary 142 thereon, as shown in FIG. 1F. The boundary 142 is projectively within the first area 111. The electronic device layer 140 can be one or more TFTs or any other electronic components.

Then, the electronic device layer 140 and the partial plastic layer 130 are separated from the substrate 110 by cutting through the plastic layer 130 along a contour that is equal to or larger than its boundary 142, but within the first area 111, as shown in FIG. 1G. Since the adhesion force between the plastic layer 130 and the substrate 110 in the first area 111 is weaker than that in the second area 113, it will be very easy to de-bond the electronic device layer 140 and the plastic layer 130 in the first area 111 from the substrate 110.

FIGS. 2A-2H shows a method for manufacturing a flexible electronic device according to another embodiment which is not in accordance with the present invention but helpful for the understanding thereof. Similarly, a flat substrate 210, such as a glass, quartz, plastic, ceramic, or metal substrate, is needed for manufacturing a flexible electronic device. The substrate 210 usually has a flat top (first) surface 212 and an opposite, second surface 214.

The method starts with forming an anti-peeling layer 220 on the flat top surface 212 of the substrate 210 with an anti-peeling material comprising a metal oxide, as shown in FIG. 2A. In one embodiment, the step of forming the anti-peeling layer 220 includes sputtering the anti-peeling material on the flat top surface 212 of the substrate 210. In another embodiment, the step of forming the anti-peeling layer 220 includes vapor coating the anti-peeling material on the flat top surface 212 of the substrate 210. In one embodiment, the anti-peeling material comprises indium tin oxide (ITO). It is understood that other anti-peeling materials and other material deposition processes can also be utilized.

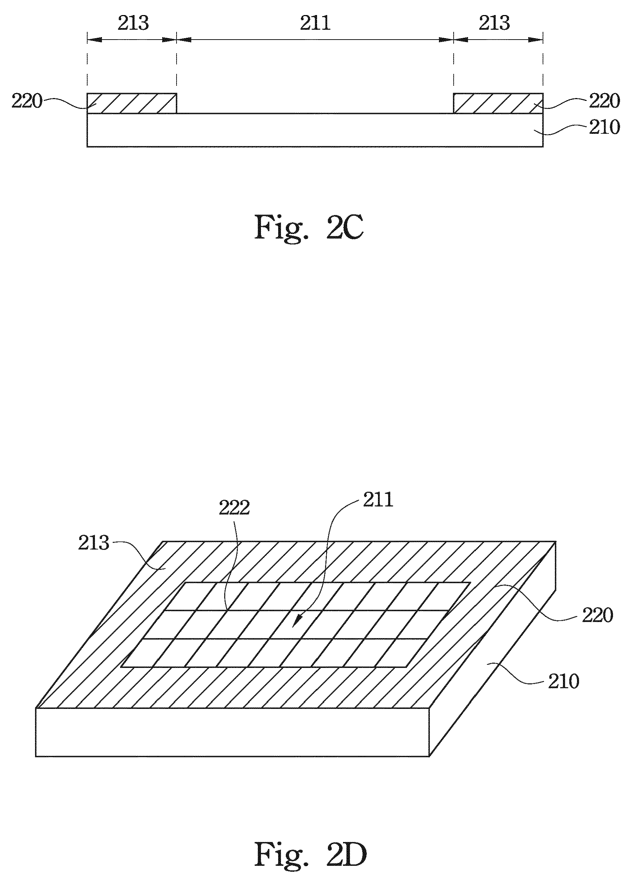

Next step is to pattern the anti-peeling layer 220 to define a first area 211 and a second area 213 surrounding the first area 211 in the substrate 210. The step of patterning the anti-peeling layer 220, in one embodiment, includes defining a photo resistor 226 having a pattern corresponding to the first area 211 and the second area 213 over the anti-peeling layer 220; etching anti-peeling layer with etchant or plasma 228 on the first area 211, and removing the photo resistor 226 on the second area 213, as shown in FIGS. 2B and 2C. The process is performed with photolithography, or the like.

In one embodiment, the anti-peeling layer 220 in the first area 211 is patterned to expose completely the top surface 212 of the substrate 210, as shown in FIG. 2C, such that the anti-peeling layer 220 is on the second area 213 only.

In another embodiment, the anti-peeling layer 220 in the first area 211 is patterned to expose partially the top surface 212 of the substrate 210, as shown in FIG. 2D. As such, the anti-peeling layer 220 is not only on the second area 213, but also partially on the first area 211 with a pattern 222, which improves the bonding between the plastic layer 230 (described below) and the substrate 210 so as to adjust the adhesion force therebetween. As shown in FIG. 2D, the patteren 222 is a mesh pattern. Other patterns such as a slit pattern, and an island pattern can also be used. In one embodiment, the unexposed portion (i.e. the patterned portion) of the first area 211 is about 0.1-30.0 % of the first area 211, and the area of the second area 213 is larger than the area of unexposed portion of the first area 211.

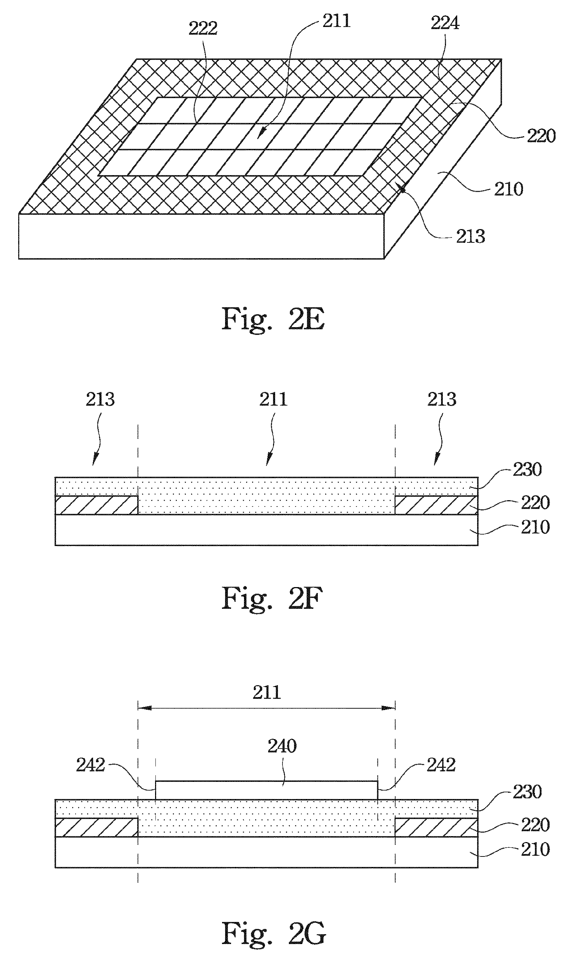

In yet another embodiment, as shown in FIG. 2E, the anti-peeling layer 220 is patterned to partially expose the top surface 212 of the substrate 210 so as to form pattern 222 and 224 of the anti-peeling layer 220 on the first area 211 and the second area 213, respectively. The pattern 222 and 224 improve the bonding between the plastic layer 230 (described below) and the substrate 210 so as to adjust the adhesion force therebetween. As shown in FIG. 2E, the pattern 222 and 224 are mesh patterns. In other embodiment, other patterns such as slit patterns, and island patterns can also be used. In one embodiment, the density of the unexposed portion (i.e. the area of the pattern 224 in the unit area of the second area 213) of the second area 213 is larger than the density of the unexposed (i.e. the area of the pattern 222 in the unit area of the first area 211) of the first area 211. In one embodiment, the total area of the anti-peeling layer 220 of the second area 213 is larger than the total area of the anti-peeling layer 220 of the first area 211. In another embodiment, the total area of the anti-peeling layer 220 of the second area 213 can be equal to or smaller than the total area of the anti-peeling layer 220 of the first area 211.

Further, a plastic layer 230 is formed on the first area 211 and the anti-peeling layer 220 over the second area 213 with PI, as shown in FIG.2F. Accordingly, the adhesion force between the plastic layer 230 and the substrate 210 in the first area 211 is weaker than that between in the plastic layer 230 and the anti-peeling layer 220 in the second area 213. In one embodiment, the step of forming the plastic layer include coating the first area 211 and the anti-peeling layer 220 on the second area 213 with polyamic acid to form a coated polyamic acid layer thereon; and curing the coated polyamic acid layer to form the plastic layer 230.

On the plastic layer 230, an electronic device layer 240 is formed over the first area 211 in which the electronic device layer 240 defines a boundary 242 thereon, as shown in FIG.2G. The boundary 242 is projectively within the first area 211. The electronic device layer 240 can be one or more TFTs or any other electronic components.

Then, the electronic device layer 240 and the the plastic layer 230 are separated from the substrate 210 by cutting through the plastic layer 230 along a contour that is equal to or larger than its boundary 242, but within the first area 211, as shown in FIG.2H. Since the adhesion force between the plastic layer 230 and the substrate 210 in the first area 211 is weaker than that in the second area 213, it will be very easy to de-bond the electronic device layer 240 and the plastic layer 230 in the first area 211 from the substrate 210.

Referring now to FIGS. 3A-3H, a method for manufacturing a flexible electronic device is shown according to one embodiment of the present invention. The method includes the following steps: at first, a substrate 310 having a flat top surface 312 and an opposite, second surface 314 is provided. Similarly, the substrate 310 can be a substrate of glass, quartz, plastic, ceramic, metal, or the like.

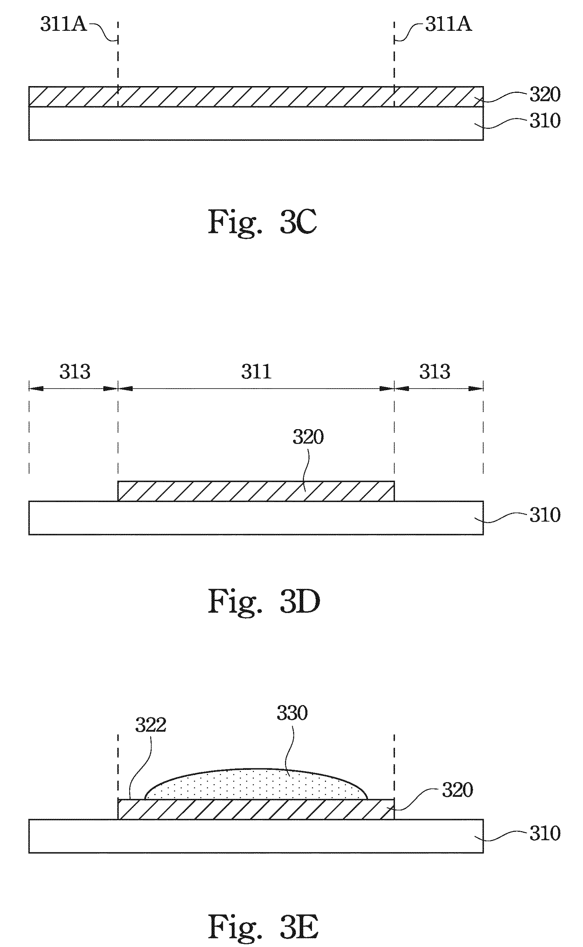

Next step is to coat a first PAA on the flat top surface 312 of the substrate 310 to form a first PI layer 320 so as to define a first area 311 on which the first PI layer 320 is formed and a second area 313 surrounding the first area 311 in the substrate 310, as shown in FIGS. 3B and 3C. The coating step may be performed by applying an excess amount of a solution of PAA to the top surface 312 of the flat substrate 310, as shown in FIG. 3A, then, rotating them at high speed to spread the solution of PAA to form a first PAA layer coated on the substrate 310, baking the coated PAA layer at a temperature of about 70-250 °C for about 5-30 min, preferably, about 150 °C for about 10 min, and then curing them at a temperature of about 200-400 °C for about 30-60 min, preferably, about 300 °C for about 60 min, to form the first PI layer 320. Further, the first area 311 and the second area 313 may be defined by a cutting process, i.e., cutting through the first PI layer 320 along a contour 311A so as to define the first area 311 within the contour 311A and the second area 313 surrounding the first area 311, and peeling off the portion of the first PI layer 320 on the second area 313, as shown in FIGS. 3C and 3D. As such, the first PI layer 320 is on the first area 311 only, while the substrate 310 is exposed in the second area 313.

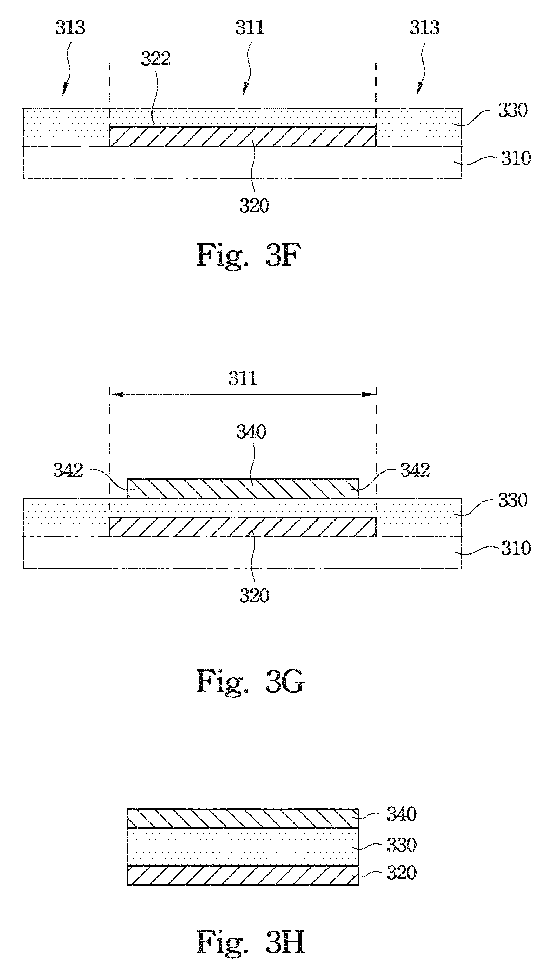

Then, a second PAA containing organic silane is coated on the first PI layer 320 in the first area 311 of the substrate 310 and on the second area 313 of the substrate 310 to form a second PI layer 330 thereon, as shown in FIGS. 3E and 3F. As such, an adhesion force between the first PI layer 320 and the substrate 310 in the first area 311 is weaker than that between the second PI layer 330 and the substrate 310 in the second area 313. Similarly, the coating step is carried out by applying an amount of a second PAA containing organic silane to the top surface 322 of the first PI layer 320, as shown in FIG. 3E, then, rotating them at high speed to spread the mixture to form a second PAA layer containing organic silane coated on the first PI layer 320, baking them at a temperature of about 70-250 °C for about 5-30 min, preferably about 150 °C for about 10 min, and then curing them at a temperature of about 200-400 °C for about 30-60 min, preferably, about 300 °C for about 60 min, to form the second PI layer 330. The first PAA and the second PAA can be the same or substantially different from one another.

On the second PI layer 330, an electronic device layer 340 is formed over the first area 311 in which the electronic device layer 340 defines a boundary 342 thereon, as shown in FIG. 3G. The boundary 342 is projectively within the first area 311. The electronic device layer 340 can be one or more TFTs or any other electronic components.

The electronic device layer 340, the first PI layer 320 and the second PI layer 330 are then separated from the substrate 310 by cutting through the first and second PI layers 320 and 330 along a contour that is equal to or larger than its boundary 342, but within the first area 311, as shown in FIG. 3H. Since the adhesion force between the first PI layer 320 and the substrate 310 in the first area 311 is weaker than that the second PI layer 330 and the substrate 310 in the second area 313, it will be very easy to de-bond the electronic device layer 340, the first PI layer 320 and the second PI layer 330 in the first area 311 from the substrate 310.

In one aspect which is not in accordance with the present invention but helpful for the understanding thereof, a method for manufacturing a flexible electronic device includes providing a substrate having a first surface and an opposite, second surface, forming a first layer on the first surface of the substrate to define a first area and a second area surrounding the first area in the substrate such that the first surface of the substrate is exposed at least partially in the first area and at least a portion of the first layer is in the second area, forming a second layer on the first area and the first layer over the second area such that an adhesion force between the second layer and the substrate in the first area is weaker than that between the second layer and the first layer in the second area, forming an electronic device layer on the second layer over the first area, where the electronic device layer defines a boundary thereon, and the boundary is projectively within the first area, and separating the electronic device layer and the second layer from the substrate by cutting through the second layer along a contour that is equal to or larger than the boundary of the electronic device layer, but within the first area.

In one embodiment of the above aspect, the step of forming the first layer comprises the step of forming an adhesion promoting layer of an adhesion promoting material on the first surface of the substrate, where the adhesion promoting material includes organic silage.

In one embodiment of the above aspect, the step of forming the adhesion promoting layer comprises the steps of coating the first surface of the substrate with the adhesion promoting material, and baking the adhesion promoting material coated substrate at a first temperature for a first period of time to form the adhesion promoting layer, where the first temperature is in a range of about 50-250 °C, and the first period of time is in a range of about 5-10 min. In another embodiment, the step of forming the first layer comprises the step of vapor coating the first surface of the substrate with the adhesion promoting material to form the adhesion promoting layer.

In one embodiment of the above aspect, the step of forming the first layer further comprises the steps of forming a mask having a pattern corresponding to the first area and the second area over the adhesion promoting layer, treating the mask with UV light in an environment of air or oxygen such that the adhesion promoting layer on the first area is illuminated with the UV light and the adhesion promoting layer on the second area is masked from the UV light, and removing a portion of the adhesion promoting layer on the first area. In one embodiment, the treating step is performed in an oven at a second temperature for a second period of time, where the second temperature is in a range of about 25-300 °C, and the second period of time is in a range of about 1-10 min.

In another embodiment of the above aspect, the step of forming the first layer comprises the step of forming an anti-peeling layer of an anti-peeling material comprising a metal oxide on the first surface of the substrate, where the anti-peeling material comprises indium tin oxide (ITO). In one embodiment, the step of forming the anti-peeling layer comprises the step of sputtering or vapor coating the anti-peeling material on the first surface of the substrate.

In one embodiment of the above aspect, the step of forming the first layer further comprises the steps of defining a photo resistor having a pattern corresponding to the first area and the second area over the anti-peeling layer, etching the anti-peeling layer with etchant or plasma on the first area so as to at least partially expose the substrate in the first area, and removing the photo resistor. In one embodiment, the first area is patterned such that the unexposed portion of the first area is about 0.1-30.0 % of the first area, and the area of the second area is larger than the area of unexposed portion of the first area, where the unexposed portion of the first area is patterned to have a slit pattern, an island pattern, or a mesh pattern.

In one embodiment of the above aspect, the step of forming the second layer comprises the steps of coating the first area and the first layer over the second area with polyamic acid to form a coated polyamic acid layer thereon, and curing the coated polyamic acid layer to form the second layer of polyimide.

The foregoing description of the exemplary embodiments of the invention has been presented only for the purposes of illustration and description and is not intended to be exhaustive or to limit the invention to the precise forms disclosed. Many modifications and variations are possible in light of the above teaching.

The embodiments were chosen and described in order to explain the principles of the invention and their practical application so as to activate others skilled in the art to utilize the invention and various embodiments and with various modifications as are suited to the particular use contemplated. Alternative embodiments will become apparent to those skilled in the art to which the present invention pertains without departing from its scope. Accordingly, the scope of the present invention is defined by the appended claims rather than the foregoing description and the exemplary embodiments described therein.

## Claims

1. A method for manufacturing a flexible electronic device, comprising the steps of:
(a) providing a substrate (310) having a first surface (312) and an opposite, second surface (314);
(b) coating a first polyamic acid on the first surface of the substrate to form a first polyimide (PI) layer (320) so as to define a first area (311) on which the first PI layer (320) is formed and a second area (313) surrounding the first area (311) in the substrate (310);
(c) coating a second polyamic acid containing organic silane on the first PI layer (320) in the first area (311) of the substrate (310) and on the second area (313) of the substrate (310) to form a second PI layer (330) thereon, such that an adhesion force between the first PI layer (320) and the substrate (310) in the first area (311) is weaker than that between the second PI layer (330) and the substrate (310) in the second area (313);
(d) forming an electronic device layer (340) on the second PI layer (330) over the first area (311), wherein the electronic device layer (340) defines a boundary thereon, and the boundary is projectively within the first area (311); and
(e) separating the electronic device layer (340), the partial second PI layer (313) and the partial first PI layer (320) from the substrate (310) by cutting through the second PI layer (330) and the first PI layer (320) along a contour that is equal to or larger than the boundary of the electronic device layer (340) but within the first area (311).

2. The method of claim 1, wherein step (b) further comprises the steps of:
cutting through the first PI layer (320) along a contour so as to define the first area (311) within the contour and the second area (313) surrounding the first area (311); and
peeling off a portion of the first PI layer (320) on the second area (313).

## Patentansprüche

1. Herstellungsverfahren für eine flexible elektronische Vorrichtung, umfassend die Verfahrensschritte:
a) Bereitstellen eines Substrats (310), mit einer ersten Fläche (312) und einer entgegengesetzten zweiten Fläche (314);
b) Beschichten der ersten Oberfläche des Substrats mit einer ersten Polyaminsäure zur Bildung einer ersten Polyimidschicht (PI) (320), so dass ein erster Bereich (311) definiert wird, auf dem die erste PI-Schicht (320) gebildet ist, und ein zweiter Bereich (313) des Substrats (310) definiert wird, der den ersten Bereich (311) umgibt;
c) Beschichten der ersten PI-Schicht (320) in dem ersten Bereich (311) des Substrats (310) und des zweiten Bereichs (313) des Substrats (310) mit einer organisches Silan enthaltenden zweiten Polyaminsäure, um hierauf eine zweite PI-Schicht (330) zu bilden, so dass eine Bindungskraft zwischen der ersten PI-Schicht (320) und dem Substrat (310) in dem ersten Bereich (311) schwächer ist als eine Bindungskraft zwischen der zweiten PI-Schicht (330) und dem Substrat (310) in dem zweiten Bereich (313);
d) Bilden einer elektronischen Vorrichtungsschicht (314) auf der zweiten PI-Schicht (330) über dem ersten Bereich (311), wobei die elektronische Vorrichtungsschicht (340) darauf eine Begrenzung definiert, und wobei die Begrenzung innerhalb des ersten Bereichs (311) hervorstehend ist; und
e) Trennen der elektronischen Vorrichtungsschicht (340), der teilweisen zweiten PI-Schicht (313) und der teilweisen ersten PI-Schicht (320) von dem Substrat (310) mittels Schneiden durch die zweite PI-Schicht (330) und die erste PI-Schicht (320) entlang eines Umrisses, der gleich der oder größer als die Begrenzung der elektronischen Vorrichtungsschicht (340) ist, sich jedoch innerhalb des ersten Bereichs (311) befindet.

2. Verfahren nach Anspruch 1, wobei Schrift b) ferner die Schritte umfasst:
Schneiden durch die erste PI-Schicht (320) entlang eines Umrisses, so dass der erste Bereich (311) innerhalb des Umrisses und der zweite Bereich (313) den ersten Bereich (311) umgebend definiert werden; und
Ablösen eines Teils der ersten PI-Schicht (320) in dem zweiten Bereich (313).

## Revendications

1. Procédé de fabrication d'un dispositif électronique flexible comprenant les étapes de :
(a) fourniture d'un substrat (310) qui a une première surface (312) et une seconde surface opposée (314) ;
(b) revêtement d'un premier acide polyamique sur la première surface du substrat pour former une première couche (320) de polyimide (PI) de manière à définir une première zone (311) sur laquelle la première couche (320) est formée et une seconde zone (313) qui entoure la première surface (311) dans le substrat (310) ;
(c) revêtement d'un second acide polyamique contenant un silane organique sur la première couche de PI (320) dans la première zone (311) du substrat (310) et sur la seconde zone (313) du substrat (310) pour former une seconde couche de polyimide (330) dessus de telle manière qu'une force d'adhésion entre la première couche de PI (320) et le substrat (310) dans la première zone (311) est plus faible qu'entre la seconde couche de PI (330) et le substrat (310) dans la seconde zone (313) ;
(d) formation d'une couche de dispositif électronique (340) sur la seconde couche de PI (330) sur la première zone (311), la couche de dispositif électronique (340) définissant une frontière sur celle-ci et la frontière étant en projection à l'intérieur de la première zone (311) et
(e) séparation de la couche de dispositif électronique (340), de la seconde couche partielle de PI (313) et de la première couche partielle de PI (320) du substrat (310) en coupant à travers la seconde couche de PI (330) et la première couche de PI (320) le long d'un contour qui est égal ou plus grand que la frontière de la couche de dispositif électronique (340) mais à l'intérieur de la première zone (311).

2. Procédé selon la revendication 1, l'étape (b) comprenant de plus les étapes de : découpage à travers la première couche de PI (320) le long d'un contour de manière à définir la première zone (311) à l'intérieur du contour et la seconde zone (313) qui entoure la première zone (311) et
pelage d'une portion de la première couche de PI (320) sur la seconde zone (313).
